# EUROPÄISCHE PATENTSCHRIFT

(11) **EP 1 658 648 B1**
(45) Veröffentlichungstag und Bekanntmachung des Hinweises auf die Patenterteilung: **25.11.2009**
(21) Anmeldenummer: 04762661.9
(22) Anmeldetag: 14.08.2004
(51) Int. Cl.: H01L 51/00

(54) **HERSTELLUNGSVERFAHREN FÜR EIN ORGANISCHES ELEKTRONISCHES BAUTEIL MIT HOCHAUFGELÖSTER STRUKTURIERUNG**
METHOD OF PRODUCTION OF ORGANIC ELECTRONIC COMPONENT WITH HIGH RESOLUTION STRUCTURING
PROCÉDÉ DE PRODUCTION D'UN COMPOSANT ÉLECTRONIQUE ORGANIQUE A STRUCTURATION HAUTE RESOLUTION

(30) Priorität: 25.08.2003 DE 10339036
(43) Veröffentlichungstag der Anmeldung: 24.05.2006
(73) Patentinhaber: PolyIC GmbH & Co. KG, 90763 Fürth (DE)
(72) Erfinder: FIX, Walter, 90427 Nürnberg (DE); MARTIN, Ronan, 91056 Erlangen (DE); ULLMANN, Andreas, 90513 Zirdorf (DE)
(74) Vertreter: Zinsinger, Norbert
(86) Internationale Anmeldenummer: PCT/DE2004/001816
(87) Internationale Veröffentlichungsnummer: WO 2005/022663

(56) Entgegenhaltungen:
- EP-A- 0 966 182
- EP-A- 1 237 207
- WO-A-02/47183
- WO-A-2004/042837
- US-A- 5 994 773
- US-A1- 2002 170 897

## Beschreibung

Die Erfindung betrifft ein massenfertigungstaugliches Herstellungsverfahren für ein organisches elektronisches Bauteil mit hochaufgelöster Strukturierung, insbesondere einen organischen Feld-Effekt-Transistor (OFET) mit kleinem Source-Drain-Abstand.

Die Schaltfrequenz und/oder die Schaltgeschwindigkeit integrierter digitaler Schaltungen wird nicht zuletzt von der Kanallänge "1" maßgeblich beeinflusst. Es hat deshalb nicht an Versuchen gefehlt, diese Kanallänge möglicht klein zu halten, das heißt einen Chip für ein organisches elektronisches Bauteil zu schaffen mit möglichst hoch aufgelöster Strukturierung.

Bekannt sind organische elektronische Bauteile, insbesondere OFETs mit hochaufgelöster Strukturierung und kleinem Source-Drain-Abstand "1". Bislang werden diese jedoch in aufwendigen Prozessschritten, die mit hohen Kosten verbunden sind, hergestellt. Diese Prozessschritte sind unwirtschaftlich und umfassen regelmäßig Fotolithographie, wobei Vertiefungen in einer unteren Schicht oder im Substrat fotolithographisch erzeugt werden, damit eine Leiterbahn mit der erforderlichen Kapazität gebildet werden kann. Diese Vertiefungen sind muldenförmig und haben keine scharfen Konturen. Der Boden dieser Vertiefungen bleibt unverändert.

Aus der WO 2002/47183 ist zwar ein großtechnisch anwendbares hochauflösender Druckverfahren bekannt, bei dem die Leiterbahnen in Vertiefungen eingebracht werden, jedoch hat das den Nachteil, dass die Vertiefungen, die durch Aufdrücken eines Prägestempels entstehen, keine steilen Wandflächen und scharf gezogene Kanten haben, sondern mehr muldenförmig und ohne scharfe Konturen ausgebildet sind. In diese Mulden mit weichen Übergängen wird dann durch Rakeln das Material in Form einer Lösung oder als Schmelze hinein gerakelt. Als Folge dieser weichen Übergänge füllt das in die Vertiefung eingebrachte Material nicht akkurat nur die Vertiefung, sondern es verwischt um die Vertiefung herum und führt damit zu Leckströmen. Das verschmierte Material lässt sich in der Folge auch nicht abwischen, ohne einen Großteil des Materials wieder aus der Vertiefung herauszuwischen.

Aufgabe der Erfindung ist es, ein großtechnisches und günstiges Verfahren zur Herstellung eines elektronischen Bauteils aus vorwiegend organischem Material anzugeben, insbesondere ein Verfahren zur Herstellung einer hochaufgelösten Struktur einer Funktinsschicht mit einem kleinen Source-Drain-Abstand, zu schaffen.

Lösung der Aufgabe und Gegenstand der Erfindung ist ein Verfahren zur Herstellung eines organischen elektronischen Bauteils bei dem zur Herstellung einer Leiterbahn und/oder einer Elektrode eine untere Schicht und/oder das Substrat mit einem Laser behandelt wird, so dass dadurch zumindest eine Vertiefung und/oder ein durch Laserbehandlung veränderter Bereich in der unteren Schicht und/oder dem Substrat erzeugt wird, dadurch charakterisiert, dass
in die Vertiefung und/oder auf den durch Laserbehandlung veränderten Bereich metallisches Material aufgesputtert und/oder aufgedampft wird und überflüssiges metallisches Material in einem dem Aufbringen dieses Materials folgenden Prozessschritt abgewischt wird, ohne dass das auf die durch Laserbehandlung veränderten Bereiche der unteren Schicht durch Sputtern und/oder Aufdampfen aufgebrachte Material dabei entfernt und/oder die Vertiefungen entleert werden.

Nach einer Ausführungsform der Erfindung ist der Abstand "1" zwischen zwei Elektroden oder zwischen einer Elektrode und einer Leiterbahn kleiner 20µm. Das entspricht einer hohen Auflösung der Strukturierung, die besonders bevorzugt sogar unter 10 µm, insbesondere noch wenigere µm beträgt. Durch die Erfindung werden Leckströme zwischen den Leiterbahnen und/oder Elektroden vermieden und deshalb kann der Abstand "1" dazwischen minimiert werden.

Nach einer Ausführungsform des Verfahrens wird überschüssiges leitfähiges Material in einem auf die Aufbringung des Materials und/oder die Befüllung der Vertiefungen mit diesem Material folgenden Prozessschritt abgewischt, ohne dass dabei leitfähiges Material aus dem aufgerauten Bereich und/oder aus der Vertiefung mit dem aufgerauten Boden in merklichem Umfang wieder entfernt würde.

Das Aufbringen des leitfähigen Materials und/oder die Befüllung der Vertiefungen kann nach verschiedenen Techniken erfolgen: Es kann aufgedampft oder aufgesputtert werden.

Nach einer Ausführungsform des Verfahrens wird die untere Schicht und/oder das Substrat mit einem gepulsten Laser, beispielsweise mit Pulslängen von einigen 10 ns, behandelt. Dabei können bereits wenige Pulse ausreichen.

Die durch Laserstrukturierung erzeugten modifizierten und/oder aufgerauten Bereiche und/oder Vertiefungen zeichnen sich dadurch aus, dass die Auflagefläche für das leitfähige Material mit Laser behandelt wurde. Dadurch unterscheiden sich modifizierte Bereiche und/oder Vertiefungen, die mit Laser erzeugt werden von den Bereichen und/oder Vertiefungen, die nicht oder beispielsweise durch Einprägen behandelt wurden, wo sich bei letzterem das überflüssige leitfähige Material, das um die Vertiefung herum verteilt ist, nicht ohne große Verluste abwischen lässt.

Für den Fall, dass die Austrittsarbeit (bezogen auf den Halbleiter) des leitfähigen Materials für das geplante elektronische Bauteil passend ist, wird das überschüssige Material einfach auf den nicht durch Laser veränderten Bereichen der unteren Schicht und/oder des Substrats entfernt, beispielsweise mechanisch (durch Wischen mit Tüchern und/oder einer Gummirolle) und die Strukturierung ist abgeschlossen.

Falls die Austrittsarbeit nicht auf den Halbleiter abgestimmt ist, kann zusätzlich z.B. eine schlecht leitende Schicht aufgebraucht werden, deren Überschuss ebenfalls mit einer mechanischen Methode wieder entfernt werden kann. Die Kombination dieser beiden leitfähigen Schichten als Elektrode oder als Leiterbahn hat nun eine große Leitfähigkeit und besitzt die passende Austrittsarbeit.

Die Strukturierung der untersten (unteren) leitfähigen Schicht (Schichten) kann zeitlich sofort nach deren Auftragung erfolgen, sie kann auch gleichzeitig mit der Strukturierung der oberen Schichten geschehen.

Die Strukturierung der unteren Schichten kann ebenfalls nachträglich, nach der Strukturierung der oberen leitfähigen Schichten erfolgen (z.B. kann eine obere bereits strukturierte Schicht als Ätzwiderstand dienen).

Der Begriff "leitfähiges Material" soll hier in keiner Weise eingeschränkt werden, da ganz verschiedene Arten von leitfähigen Materialien an der Stelle bereits erfolgreich eingesetzt wurden.

Als leitfähiges Material kann beispielsweise ein Metall, eine Legierung, eine Metallpaste oder eine organische leitfähige Verbindung aufgedampft, aufgesputtert oder eingerakelt oder sonst wie aufgebracht werden. Entscheidend ist nur, dass das eingebrachte leitfähige Material auf der vom Laser aufgerauten Oberfläche haftet.

Als bevorzugte Metalle werden Silber, Gold, Aluminium, Kupfer etc. sowie beliebige Mischungen, Legierungen dieser Komponenten genannt, die gasförmig, flüssig, als Tinte oder Metallpaste (Metallpartikel in einem flüssigen Medium) und auch als Feststoff aufgebracht werden können.

Bevorzugte organische Materialien, die sich eben auch mit einer unteren leitfähigen Schicht, beispielsweise aus Metall kombinieren lassen, sind PANI, PEDOT und Carbon Black.

"Modifiziert" wird hier gebraucht für Bereiche einer unteren Schicht oder eines Substrats, die durch Laserbehandlung verändert sind.

Im folgenden wird die Erfindung noch anhand dreier Figuren näher erläutert, die beispielhaft und schematisch wiedergeben, wie im Querschnitt gesehen erfindungsgemäß eine Leiterbahn/Elektrode hergestellt wird.

Bilder A bis C zeigen ein Substrat und/oder eine untere Schicht, die durch ein Verfahren nach der Erfindung behandelt werden:
A1, B1 und C1 zeigen ein gereinigtes Substrat oder eine gereinigte untere Schicht. Diese wird zunächst durch Laserbehandlung so modifiziert, dass ein Bereich mit einer modifizierten und/oder aufgerauten Oberfläche und/oder eine Vertiefung entsteht (Figuren A2, B2 und C2). Möglich ist auch, dass durch die Behandlung mit Laser eine vorhandene Rauhigkeit der Oberfläche beseitigt wird und der modifizierte Bereich demnach eine geringere Rauhigkeit hat als der nicht durch Laserbehandlung modifizierte.

Gemäß den Figuren A2, B2 und C2 ist jedoch die Rauhigkeit der modifizierten Bereiche größer als die der nicht modifizierten.

Im folgenden Prozessschritt A3, B3 und C3 wird großflächig leitfähiges Material aufgebracht.

Danach wird das überschüssige Material entfernt, es bilden sich bevorzugt scharf abgezeichnete Bereiche in denen leitfähiges Material ein- und/oder aufgebracht ist und andere, die frei von leitfähigem Material sind siehe Figur A4.

Gemäß der Ausführungsform B wird im Prozessschritt B4 auf die noch unstrukturierte hochleitfähige, beispielsweise metallische Schicht noch eine weitere leitfähige Schicht, beispielsweise aus organischem Material oder Funktionspolymer aufgebracht (Y). Diese kann nun mechanisch entfernt werden (B5). Falls die hochleitfähige Schicht nicht mechanisch entfernt (strukturiert) werden kann, wird nach dem Prozessschritt B5 eine andersartige (z.B. chemische) Methode gewählt, um die hochleitfähige Schicht zu strukturieren. Die hochleitfähige Schicht (x) wird an den "modifizierten" oder aufgerauten Stellen bedeckt und kann hier nicht entfernt werden (B5). Nach der chemischen Strukturierung (z.B. ein Ätzprozess) liegt in (B6) die Kombination der hochleitfähigen (beispielsweise metallischen) und der leitfähigen (beispielsweise polymeren) Schicht in strukturierter Form vor.

Bei C4 wird ebenfalls eine weitere leitfähige Schicht aufgebracht und anschließend werden beide leitfähigen Schichten mechanische strukturiert (C5).

Mit dem Prozess nach der Erfindung können leitfähige Strukturen hergestellt werden, die:
- aus mehreren Schichten (versch. Leitfähigkeit) bestehen um z.B. die passende Austrittsarbeit zu gewährleisten.
- hochleitfähig bzw. im "Paket" hochleitfähig sind.
- kostengünstig sind, da nur wenige (3,4,5) Prozessschritte benötigt werden.
- die benötigte Auflösung haben (möglichst kleine Struktur)
- die auf einem massenfertigungstauglichen und schnellen Prozess basieren.

Die Vorteile liegen auch in der einfachen Herstellungsmethode da nur 3 Prozessschritte benötigt werden (z.B. Laserstrukturierung , leitfähige Schicht aufbringen, Strukturierung der leitfähigen Schicht). Beispielsweise können durch die Verwendung von metallischen Leitern (fest oder flüssig) wiederum beispielsweise in Kombination mit weiteren Leitern aus organischem Material sehr hoch leitfähige kleine Strukturen erstellt werden, ohne das ein Spannungsabfall in den Leiterbahnen problematisch wird. Zusätzlich kann die Austrittsarbeit angepasst werden. Mit Verwendung dieser Technik kann die Schaltungsgröße minimiert werden, wodurch sich ebenfalls die Kosten in gleichem Maße reduzieren.

Das Substrat wird beispielsweise im Rolle-zu-Rolle-Verfahren zwischen mehreren Walzen hindurchgezogen. Im ersten Arbeitsgang werden dann mit einem Laser, beispielsweise einem Excimer-Laser, durch eine Maske Vertiefungen und/oder modifizierte oder aufgeraute Bereiche im Substrat oder einer unteren Schicht erzeugt. Der Excimer-Laser ist gegebenenfalls mit optischen Linsensystemen ausgestattet, so dass die Vertiefungen/Bereiche nicht unbedingt in derselben Größe abgebildet werden wie die Maske sie vorgibt.

Bei der mechanischen Strukturierung wird eventuell vorhandenes leitfähiges Material zwischen den Vertiefungen/Bereichen beispielsweise mit einer saugfähigen Rolle im roll-to-roll Verfahren entfernt. Die Rolle dreht sich beispielsweise langsamer als die anderen Rollen, so dass effektiv gewischt wird. Der Begriff "organisches Material" oder "Funktionsmaterial" oder "(Funktions-)Polymer" umfasst hier alle Arten von organischen, metallorganischen und/oder organisch-anorganischen Kunststoffen (Hybride), insbesondere die, die im Englischen z.B. mit "plastics" bezeichnet werden. Es handelt sich um alle Arten von Stoffen mit Ausnahme der Halbleiter, die die klassischen Dioden bilden (Germanium, Silizium). Eine Beschränkung im dogmatischen Sinn auf organisches Material als Kohlenstoff enthaltendes Material ist demnach nicht vorgesehen, vielmehr ist auch an den breiten Einsatz von z.B. Siliconen gedacht. Weiterhin soll der Term keiner Beschränkung im Hinblick auf die Molekülgröße, insbesondere auf polymere und/oder oligomere Materialien unterliegen, sondern es ist durchaus auch der Einsatz von "small molecules" möglich. Der Wortbestandteil "polymer" im Funktionspolymer ist historisch bedingt und enthält insofern keine Aussage über das Vorliegen einer tatsächlich polymeren Verbindung.

Durch die Erfindung wird erstmals ein Verfahren vorgestellt, mit dem ein organisches elektronisches Bauelement wie ein OFET, der durchaus auch metallische Komponenten und Schichten umfassen kann, mit hoher Schaltgeschwindigkeit und hoher Zuverlässigkeit wirtschaftlich hergestellt werden kann. Es hat sich gezeigt, dass Vertiefungen und/oder Bereiche, die mit einem Laser hergestellt werden, die Aufbringung von leitfähigem organischen Material anders halten als die herkömmlichen Vertiefungen/Strukturierungen und, dass deshalb mit dieser Methode Leiterbahnen organische und metallischer Natur schneller und besser herstellbar sind als nach anderen Methoden.

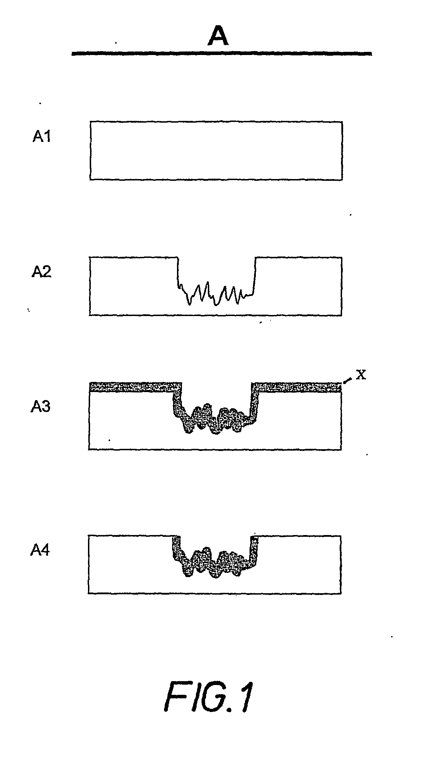

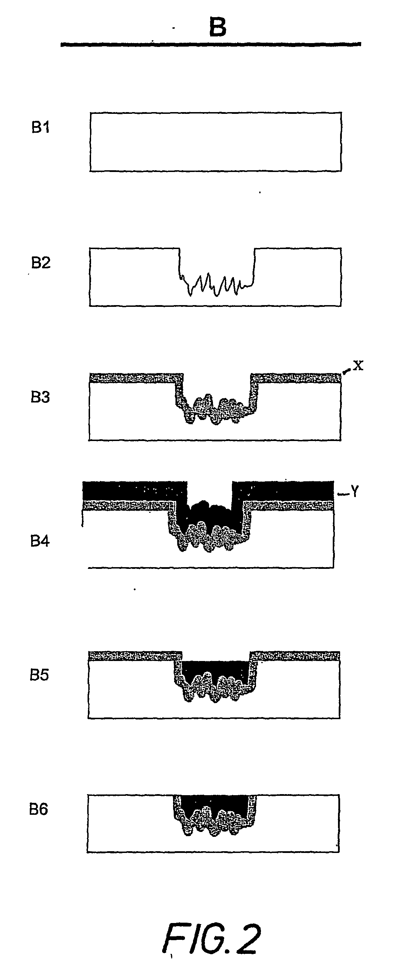

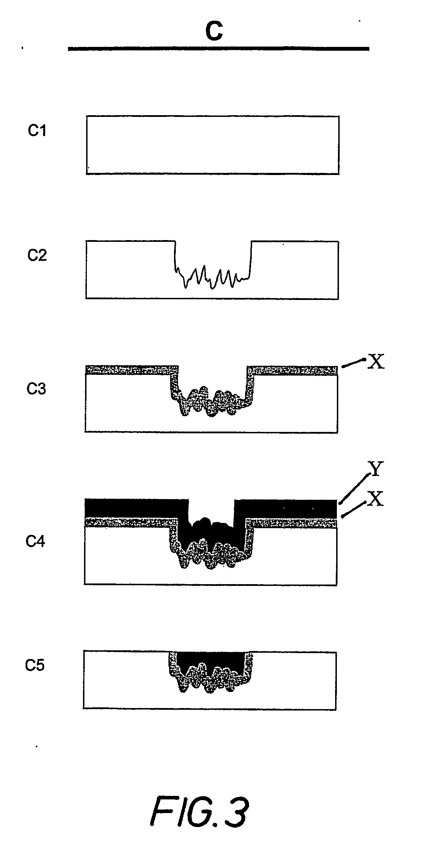

## Patentansprüche

1. Verfahren zur Herstellung eines organischen elektronischen Bauteils bei dem zur Herstellung einer Leiterbahn und/oder einer Elektrode eine untere Schicht und/oder das Substrat (1) mit einem Laser (3) behandelt wird, so dass **dadurch** ein durch Laserbehandlung veränderter Bereich (5) in der unteren Schicht und/oder dem Substrat (1) erzeugt wird,
**dadurch** charakterisiert, dass
auf den durch Laserbehandlung veränderten Bereich (5) metallisches Material durch Sputtern und/oder Aufdampfen aufgebracht wird und überschüssiges metallisches Material in einem dem Aufbringen dieses Materials folgenden Prozessschritt (8) abgewischt wird, ohne dass das auf die durch Laserbehandlung veränderten Bereiche (5) der unteren Schicht (1) aufgebrachte Material dabei entfernt wird.

2. Verfahren nach Anspruch 1, bei dem die durch Aufsputtern und/oder Aufdampfen von metallischem Material auf die durch Laserbehandlung veränderten Bereiche (5) erhaltene leitfähige Schicht mechanisch strukturiert wird.

3. Verfahren nach einem der Ansprüche 1 oder 2, bei dem ein gepulster Laser (3), beispielsweise ein Excimer-Laser (3) eingesetzt wird.

4. Verfahren nach einem der Ansprüche 1 bis 3, das in einem kontinuierlichen roll-to-roll Prozess durchgeführt wird.

## Claims

1. Method for producing an organic electronic component in which, in order to produce a conductor track and/or an electrode, a lower layer and/or the substrate (1) are/is treated with a laser (3) such that a region (5) altered by laser treatment is thereby produced in the lower layer and/or the substrate (1), **characterized in that** metallic material is applied to the region (5) altered by laser treatment by sputtering and/or vapour deposition, and superfluous metallic material is wiped off in a process step (8) following the application of this material, without in this case removing the material applied to the regions (5) of the lower layer (1) which are altered by laser treatment.

2. Method according to Claim 1, in which the conductive layer obtained by sputtering and/or vapour depositing metallic material into the regions (5) altered by laser treatment are mechanically structured.

3. Method according to either of Claims 1 and 2, in which a pulsed laser (3), for example an excimer laser (3), is used.

4. Method according to one of Claims 1 to 3, which is carried out in a continuous roll-to-roll process.

## Revendications

1. Procédé de production d'un composant électronique organique, dans le cas duquel une couche inférieure et/ou le substrat (1) est traité avec un laser (3) en vue de la génération d'une piste conductrice et/ou d'une électrode de manière à ce qu'une zone (5) modifiée via traitement au laser soit ainsi générée dans la couche inférieure et/ou dans le substrat (1),
**caractérisé en ce que**
de la matière métallique est appliquée via pulvérisation cathodique et/ou évaporation sous vide sur la zone (5) modifiée via traitement au laser et de la matière métallique en excédent est enlevée dans une phase de processus (8) consécutive à l'application de ladite matière sans que la matière appliquée sur les zones (5) modifiées via traitement au laser de la couche inférieure (1) y soit retirée.

2. Procédé selon la revendication 1, dans le cas duquel la couche conductrice obtenue via pulvérisation cathodique et/ou évaporation sous vide de matière métallique sur les zones (5) modifiées via traitement au laser est structurée mécaniquement.

3. Procédé selon l'une quelconque des revendications 1 ou 2, dans le cas duquel un laser pulsé (3), par exemple un laser excimère (3), est utilisé.

4. Procédé selon l'une quelconque des revendications 1 à 3, qui est exécuté selon un processus roll-to-roll continu.
